Europäisches Patentamt

European Patent Office

Office européen des brevets

(11) Publication number: **0 111 804**
**B1**

## (12) EUROPEAN PATENT SPECIFICATION

(45) Date of publication of patent specification: **16.09.87**

(51) Int. Cl.⁴: **H 01 L 29/747**

(21) Application number: **83112187.6**

(22) Date of filing: **03.12.83**

(54) **Bidirectional insulated-gate rectifier structures and method of operation.**

(30) Priority: **13.12.82 US 449322**

(43) Date of publication of application:
**27.06.84 Bulletin 84/26**

(45) Publication of the grant of the patent:
**16.09.87 Bulletin 87/38**

(84) Designated Contracting States:
**DE FR NL**

(56) References cited:
**EP-A-0 040 816**
**EP-A-0 064 715**
**GB-A-2 088 631**

**IEEE TRANSACTIONS ON ELECTRON DEVICES, vol. ED-27, no. 2, February 1980, New York J.D. PLUMMER et al. "Insulated-gate planar thyristors: I - Structure and basic operation", pages 380-387**

(73) Proprietor: **GENERAL ELECTRIC COMPANY**
**1 River Road**
**Schenectady New York 12305 (US)**

(72) Inventor: **Baliga, Bantval Jayant**
**3 Clove Court**
**Clifton Park New York 12065 (US)**

(74) Representative: **Schüler, Horst, Dr. et al**
**Kaiserstrasse 41**
**D-6000 Frankfurt/Main 1 (DE)**

## Description

The present invention relates generally to insulated-gate rectifiers according to the first part of claim 1 and 6, respectively, and to a method of operating such bidirectional rectifiers according to the first part of claim 9.

Such rectifiers and method for operating is known from IEEE Transactions on Electron Devices, Volume ED—27, No. 2, February 1980, J. D. Plummer et al. "Insulated-gate planar thyristors ...", pages 380 to 387.

Various forms of insulated-gate rectifiers are disclosed in commonly-assigned DE—A—31 47 075 by B. J. Baliga and entitled "GATE ENHANCED RECTIFIER". (It may be noted that a "Gate Enhanced Rectifier" or "GERECT", is alternatively referred to herein as an "Insulated-Gate Rectifier", or "IGR". The two terms are intended to mean the same device.)

As described in detail in the above-identified Baliga Application DE—A—31 47 075 an insulated-gate rectifier (IGR) is a semiconductor device having an insulated gate for controlling current flow between its main terminals, i.e., between its anode and cathode terminals. The gate and conduction channel of an IGR are similar to corresponding elements in a metal-oxide-semiconductor field-effect transistor (MOSFET) or, more generically, an insulated-gate field-effect transistor (IGFET) with, however, important differences between the two devices (an IGR and a MOSFET) as described in detail in the above-identified DE—A—31 47 075.

A basic IGR has both forward and reverse blocking capability (with the exception of anode-shorted versions as summarized hereinbelow). However, current can be controlled in only the forward direction via the insulated gate. In the reverse direction, the device either always blocks, in the case of a basic IGR, or always conducts, in the case of an anode-shorted IGR. It will be appreciated that, for some circuit applications, this single-polarity control capability is a limitation, and that for some circuit applications it is desirable to have devices capable of controlling current flow for both applied polarities.

Previously-disclosed IGR's may appear to be structurally similar to double-diffused MOS (DMOS) or "V"-groove MOS (VMOS) vertical-channel MOSFETs, with, however, an important distinction. In particular, assuming the case of an N-channel device, a $P^+$ (or highly-doped P conductivity type) anode region, not found in a MOSFET, is included. A four-layer, i.e., PNPN, device therefore results. Operation also differs from that of a MOSFET, a most significant difference being that the IGR has higher forward conductivity.

Considering the structure in greater detail, in a conventional N-channel power MOSFET, an N (or high resistivity N conductivity) drift region forms an extension of the MOSFET drain terminal region. Conduction in such a MOSFET occurs primarily by simple electron current flow through a depletion channel induced in a shield base region by an electric field from an insulated gate electrode, without the presence of excess carriers. Due to the lack of excess carriers, the MOSFET has a relatively fast switching speed.

In contrast, in an IGR, the $P^+$ anode region injects minority carriers (e.g., holes) into the N conductivity type region corresponding to the drift region of a MOSFET. The drift region of an SCR constitutes what, for convenience, is herein termed an "active-base" region, signifying that conduction in this particular region involves more that the mere flow of majority carriers, e.g. electrons. Rather, during operation, the holes introduced into the region herein termed the active-base region recombine with electrons introduced from the cathode, increasing device conductivity. The conduction mode is therefore bipolar in part.

An IGR differs from a four-layer PNPN thyristor, even though some forms of IGR are superficially somewhat similar structurally to MOS-gated SCR or thyristor structures, and even though an IGR may be considered as including a parasitic SCR. Significantly, in the normal operation of an IGR, the gate electrode maintains both turn-on and turn-off control of current flow through the device, and the parasitic SCR is bot permitted to latch into a conducting state.

As also described in the above-identified DE—A—31 47 075, there are various methods by which the parasitic SCR can be inhibited from operating (which would undesirably latch the device into a conducting state with loss of gate control). A basic approach is to employ a short between the device cathode region and the adjacent P conductivity type shield base region. For convenience, such a short is herein termed a "cathode short", and a given device accordingly has a cathode shorting density determined by the relative contact areas of the cathode electrode with the P-type shield base region and with the $N^+$ cathode region itself. In an SCR, a relatively high cathode shorting density relative to the cathode shorting density which would be employed in a thyristor structure is employed. Another approach for preventing the parasitic SCR from latching into an undesired current-carrying state is a structure disclosed in commonly-assigned EP 83 103 196.8 by M. S. Adler and B. J. Baliga and entitled "INSULATED-GATE RECTIFIER WITH IMPROVED CURRENT-CARRYING CAPABILITY". In the structure disclosed therein, the IGR shield base region includes two portions. One of these portions is doped substantially higher in concentration than the other to reduce its resistance to hols, and additionally comprises a deeper diffused region than the other portion.

As further described in the above-identified DE—A—31 47 075, to increase turn-off speed, shorts between the device anode region and the adjacent N-type active-base region may be employed. For convenience, these shorts are herein termed "anode shorts". Anode shorts aid in improving turn-off speed of an IGR due to the bipolar conduction mode of an IGR. In particular, during conduction in an IGR, there are excess electrons and holes in the active-base region and, upon turn-off, these excess electrons and holes are momentarily trapped in the active-base region, prolonging device conduction and therefore degrading turn-off speed. Excess holes in the N conductivity type active base region of an IGR exit towards the cathode electrode through the P conductivity type shield base region. However, in the absence of an anode short, there is no similar path for excess electrons in the active base region. The inclusion of anode shorts overcomes this particular shortcoming, with the result that the device turn-off speed is enhanced.

A disadvantage, however, of anode shorts is that the device no longer has useful reverse blocking capability although for convenience, it is still termed a "rectifier". One device characteristic which is, of course, improved is turn-off speed. Another disadvantage is that the anode injection efficiency is reduced, and this particular factor results in decreased forward current density. (However, it is possible to improve device forward conduction because the thickness of the N conductivity type active-base region can be reduced.)

A structural alternative to conventional anode shorts is disclosed in commonly-assigned EP 82 108 864.8 by B. J. Baliga and entitled "SEMICONDUCTOR DEVICE HAVING RAPID REMOVAL OF MAJORITY CARRIERS FROM AN ACTIVE BASE REGION THEREOF AT DEVICE TURN-OFF AND METHOD OF FABRICATING THIS DEVICE." In the structure disclosed therein, highly-doped $N^+$ or $N^{++}$ diffusions are interspersed within the $P^+$ anode region, which similarly enables the rapid removal of excess electrons in the N conductivity type active-base region upon device turn-off. This form of passive short also, however results in the loss of device reverse blocking capability, and decreases forward current density because anode injection efficiency is reduced.

Summary of the Invention

It is an object of the invention to provide bidirectional IGR structures capable of controlling current flow for both applied polarities.

It is another object of the invention to achieve the higher turn-off switching speed of an anode-shorted IGR, without the disadvantages of degraded reverse blocking capability and degraded anode injection efficiency.

A bidirectional insulated-gate rectifier according to the invention as claimed comprises a body of semiconductor material including an active base region of one conductivity type, for example, of N conductivity type.

First and second shield base regions of opposite conductivity type, in this example, of P conductivity type, are formed in the body. To achieve a bipolar conduction mode, the shield base regions include at least portions doped higher in concentration than the active base region.

The bidirectional IGR additionally includes first and second main terminal structures spaced from the active base region by the shield base regions to define respective channel portions in the shield base regions extending between the respective terminal structures and the active base region. The main terminal structures respectively include first and second main terminal electrodes, as well as first and second highly-doped main terminal regions of the one conductivity type, in this example, $N^+$ regions. To provide shorts, the main terminal electrodes contact both the respective main terminal region and the respective shield base region. Thus active anode shorted IGRs are provided which achieve higher turn-off speed of anode-shorted IGRs without the loss of blocking capability or a decrease in forward current density.

Finally, first and second insulated gate electrodes are respectively disposed over the channel portions and insulatingly spaced therefrom. The gate electrodes are configured for respectively inducing in the channel portions, when gate voltage is applied to the gate electrodes, respective inversion channel regions of the one conductivity type conductively coupling the respective main terminal structure and the active base region. In this example, the induced inversion channels are of N conductivity type, and are induced when positive gate voltage is applied. The structure thus provided supports conduction in one direction when one of the inversion channels is induced, and ceases to support conduction in the one direction when the one inversion channel is no longer induced. The bidirectional rectifier supports conduction in the other direction when the other of the inversion channels is induced, and ceases to support conduction in the other direction when the other inversion channel is no longer induced.

The bidirectional rectifier summarized above is operated in a manner which provides active anode shorting. Thus, an aspect of the invention as claimed is the concept of active anode shorting of IGRs. As a result, the higher switching speeds which result from anode shorting are realized, without the loss of either reverse blocking capability or or forward current density as is experienced with passive anode shorting. The active anode shorting concept may be applied for either polarity although, for convenience, it is primarily described herein in the context of one conduction polarity. However, as will be appreciated, since the preferred device is symmetrical, the active anode shorting concept can be applied to device conduction in the opposite direction.

More particularly, one of the device terminal electrodes is arbitrarily termed an anode electrode, with positive polarity operating voltage applied, and the other terminal electrode termed the device cathode terminal, with negative polarity operating voltage applied.

The device is conditioned to support forward conduction by applying gate voltage to the cathode-side insulated-gate electrode for inducing an inversion channel to conductively conduct the cathode terminal region and the active base region. At the same time, insufficient voltage is applied to the anode-side insulated-gate electrode such that no inversion channel is induced in the anode shield base region between the anode terminal region and the active base region. Bipolar conduction in the N conductivity type active-base region results because electrons from the cathode region are conducted through the induced inversion channel into the active base region and, at the same time, holes are injected from the anode shield base region (of P conductivity type) into the active base region. Since the anode is not shorted, good injection efficiency of the anode is maintained.

The device is subsequently conditioned into the forward blocking state by removing the gate voltage from the cathode-side insulated-gate electrode such that the inversion channel connecting the cathode terminal region and the active base region no longer exists and, at the same time, applying gate voltage to the anode insulated-gate electrode to induce an inversion channel in the anode shield base region to conductively connect the anode terminal region and the active base region. This cuts off the primary conduction channel which is created by inversion in the cathode shield base region and, at the same time, creates a shorting path in the anode shield base region from the N conductivity type active base region to the anode electrode. This short provides a path for rapid removal of electrons in the N conductivity type active base region. Excess holes in the N conductivity active base region are removed via the cathode P conductivity type shield base region, as in a basic IGR structure.

Brief Description of the Drawings

While the novel features of the invention are set forth with particularity in the appended claims, the invention both as to organization and content, will be better understood and appreciated from the following detailed description taken in conjunction with the drawings, in which:

FIG. 1 is a highly-schematic sectioned isometric view of a bidirectional IGR structure in accordance with the invention, with portions broken away to more clearly show the geometry of the semiconductor body surface;

FIG. 2 is a cross-sectional view of an alternative form of device wherein the P conductivity type shield base regions are each in two portions, one portion being doped substantially higher in concentration than the other;

FIG. 3 depicts the device of FIG. 2 connected in an electrical circuit for operation as an actively anode-shorted IGR; and

FIG. 4 is a timing diagram depicting the manner in which the device of FIG. 3 is gated during operation.

Description of the Preferred Embodiments

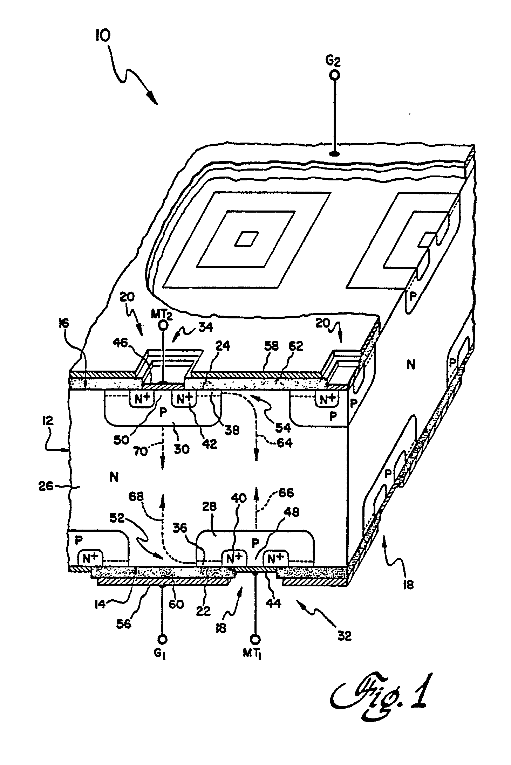

Referring first to FIG. 1, depicted is an active portion of a bidirectional insulated-gate rectifier (IGR) 10 fabricated, for purposes of example, as a vertical-channel device employing DMOS technology. It will be appreciated, however, that other forms of device may be fabricated, for example, employing VMOS technology. The device 10 includes a body 12 of semiconductor material, such as silicon, having first and second principal surfaces 14 and 16 formed on opposite sides of the body 12. Formed generally at the first principal surface 14 are a first plurality of representative unit cells 18. A corresponding second plurality of representative unit cells 20 are formed generally at the second principal surface 16. From FIG. 1, it will be appreciated that the unit cells 18 of the first plurality and the unit cells 20 of the second plurality are essentially identical, but are symmetrically laterally offset with respect to each other for maximum forward current conductivity during operation.

Considering in detail the structure of one of the identical unit cells 18 and one of the identical unit cells 20, the body 12 includes at least first and second channel surfaces 22 and 24, illustrated as being on opposite sides of the body 12. The body 12 additionally includes, and comprises in major part, an active-base region 26 of one conductivity type, for example of N conductivity type.

Formed in the body 12 respectively adjacent the channel surfaces 22 and 24 are first and second shield base regions 28 and 30 of opposite conductivity type, in this example, of P conductivity type. The shield base regions 28 and 30 include at least portions doped higher in concentration than the active base region 26. In the embodiment of FIG. 1, the shield base regions are doped substantially uniformly in concentration.

First and second main terminal structures, generally designated 32 and 34, are formed in the body 12 spaced from the active base region 26 by the shield base regions 28 and 30 to respectively define channel portions 36 and 38 within the shield base regions 28 and 30 extending between respective ones of the main terminal structures 32 and 34 and the active base region 26 just below the surfaces 22 and 24.

More particularly, the main terminal structures 32 and 34 further include respective first and second highly-doped main terminal regions 40 and 42 of the one conductivity type, e.g. $N^+$ type, formed in the semiconductor body 12 within the shield base regions 28 and 30. The main terminal structures 32 and 34 further include terminal electrodes 44 and 46, comprising for example aluminum, respectively in contact with the terminal regions 40 and 42. To provide conventional shorts between each of the main terminal regions 40 and 42 and the respective shield base region 28 or 30, the main terminal electrodes 44 and 46 respectively additionally contact shorting extensions 48 and 50, respectively, of the shield base regions 28 and 30, respectively. The metallized terminals are in turn connected, respectively, to representative device Main Terminals, $MT_1$ and $MT_2$, shown in highly-schematic form.

Although only the surface geometry at the second principal surface 16 is visible in FIG. 1, it will be appreciated that the same geometry is employed at the first principal surface 14, except for a lateral offset, as described hereinafter.

It will also be appreciated that the P type shield base regions 28 and 30, and the $N^+$ type terminal regions 40 and 42 may be formed by double-diffusion technique as are conventionally employed in the fabrication of power MOSFETs.

While the device 10 illustrated in Fig. 1 includes $N^+$ type main terminal regions 40 and 42, such is not strictly necessary in an IGR, as a sufficient N conductivity type accumulation region can in some cases be formed in the P conductivity type shield base regions 28 and 30 by inversion under the influence of electric fields from the gate electrodes, which are described hereinafter.

The main terminal structures 32 and 34 and associated shield base regions 28 and 30 have the effect of generally defining primary regions within the active base region 26. More particularly, a first primary active base region is located generally at 52. The first primary active base region, as herein employed, is that general region of the active base region 26 into which electrons from the first main terminal region 40 are channeled during device conduction when the first main terminal $MT_1$ is biased negatively with respect to the second main terminal $M_2$. Similarly, a second primary active base region 54 is that general region of the active base region 26 into which electrons from the second main terminal region 42 are channeled during device conduction when the second main terminal $M_2$ is biased negatively with respect to the first main terminal $MT_1$. It will be appreciated, however, that these primary regions 52 and 54 are highly generalized regions, and do not have definite boundaries.

It is a feature of the device structure depicted in FIG. 1 that the unit cells 18 of the first or lower set and the unit cells 20 of the second or upper set are laterally and symmetrically offset with respect to each other such that the first shield base region 28 is generally aligned with the second primary active base region 54, and the second shield base region 30 is generally aligned with the first primary active base region 52. As a result, as will be apparent from the operational description hereinafter, the highest possible device forward conductivity is achieved.

Typical doping concentrations (that is, the number of dopant atoms per cubic centimeter) for the various regions of the bidirectional insulated-gate rectifier 10 are in order of the following numbers:

The main terminal regions 40 and 42: $> 1 \times 10^{19}$;

The active base region 26: $1 \times 10^{14}$ to $5 \times 10^{15}$;

The shield base regions 28 and 30: $1 \times 10^{16}$ to $5 \times 10^{18}$.

The device 10 additionally includes first and second sets of insulated-gate electrodes 56 and 58 formed respectively over the channel surfaces 22 and 24 and configured for respectively inducing in the channel portions 36 and 38, when gate voltage is applied, respective insertion channel regions of the one conductivity type, e.g. of N conductivity type, conductively coupling the respective main terminal structure 32 or 34 and the active base region 26, or, more particularly, coupling the respective main terminal region 40 or 42 and the primary region 52 or 54 of the active base region 26. The gate electrodes 56 and 58 are insulated from the semiconductor body 12 by respective underlying insulating layers 60 and 62 which may comprise, for example, silicon dioxide or silicon nitride. The gate electrodes 56 and 58 may, for example, comprise aluminum or highly-doped polycrystalline silicon of either conductivity type, as is known in the art. The gate electrodes 56 and 58 are electrically connected to representative device Gate terminals, $G_1$ and $G_2$, respectively shown in highly-schematic form.

Although one particular form of surface geometry is shown, i.e., with nearly square unit cells, it will be appreciated that different surface geometries may be employed. Typical examples are elongated strips, and various forms of concentric circles. Further, various techniques may be employed in fabricating the main terminal electrodes 44 and 46. For example, completely encased gate electrode structures 56 and 58 may be employed with remote gate contacts (not shown) made thereto, in combination with terminal metallization 44 and 46 entirely covering both surfaces of the device 10.

In the particular configuration depicted, it will be appreciated that the gate insulating layers 60 and 62, respectively, and the conductive gate electrodes 56 and 58, respectively, substantially entirely cover both surfaces 14 and 16, respectively, of the device 10, with the exception of windows at the centers of the unit cells 18 and 20, respectively, providing access to the main terminal electrodes 44 and 46, respectively.

It will be appreciated from its symmetrical configuration that the device 10 is bidirectional in operation. In general, for either main terminal $MT_1$ or $MT_2$, respectively, biased positively with respect to the opposite main terminal, a positive voltage applied to the opposite gate terminal $G_2$ or $G_1$, respectively, with respect to the opposite main terminal $MT_2$ or $MT_1$, respectively, causes the device 10 to turn on, i.e., to be biased into forward conduction.

More particularly, considering $MT_1$ to be biased positively with respect to $MT_2$, a positive gate voltage applied via terminal $G_2$ (with respect to $MT_2$) to the second gate electrode 58 induces an N conductivity type inversion channel 38 in the second shield base region 30, whereby electrons from the second main terminal region 42 are injected into the active base region 26 or, more particularly, into the primary region 54 of the active base region 26. Electron flow from $MT_2$ is represented by a highly-schematic electron current path 64. Considering the positively-biased side of the device 10, i.e. the side with $MT_1$, a hole current path 66 is provided by virtue of the shorting connection of the first terminal electrode metallization 44 to the first shield base region 28.

Holes are accordingly injected from the first shield base region 28 into the active base region 26. Electrons in the electron current path 64 recombine with holes in the hole current path 66 to form the bulk of the current in the IGR 10.

To turn off the device, positive gate voltage is removed from the second gate electrode 58, and the inversion channel 38 no longer exists. At this point, the device 10 no longer sustains conduction.

In the opposite case, i.e., with the main terminal $MT_2$ and the second main terminal electrode 46 biased positively with respect to the first main terminal electrode $MT_1$ and the first main terminal electrode 44, a corresponding conduction mode occurs, except in the opposite direction. For the opposite case, a representative electron current path is designated 68, and a representative hole current path is designated 70.

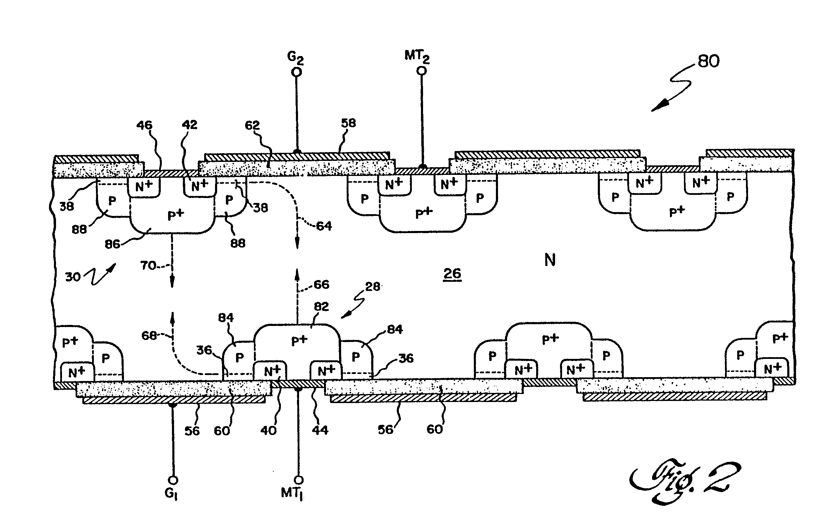

Referring now to FIG. 2, shown in cross-sectional form is a modified bidirectional IGR 80 which achieves even higher forward conductivity (in either of the two directions) than the IGR 10 of FIG. 1. In the IGR 80 of FIG. 2, the first and second shield base regions 28 and 30 are each separated into two portions, with one of these portions in each case doped substantially higher in concentration than the other. The structure on each of the upper and lower sides of the device 80 is thus similar to the structure disclosed in the above-referenced commonly-assigned EP 83 103 196.8 in the context of a single-directional IGR. However, the P conductivity type shield base region which is doped substantially higher in concentration has an additional function beyond that of the P type base region in the structure disclosed in the above mentioned application.

Referring in greater detail to FIG. 2, in overall form and in surface geometry the device 80 is substantially identical to the device 10 of FIG. 1. Considering an exemplary first P-type region 28, the region 28 comprises two portions 82 and 84. The portion 84 is adjacent to the gate insulating layer 60 and contains the inversion channel 36. The portion 82 extends from the terminal electrode 44 and has a substantially higher doping concentration than the portion 84, and as shown in FIG. 2 may also have a greater depth. By way of example, the P-type portion 82 has a doping concentration in the order of $1 \times 10^{19}$, in contrast to the doping concentration of the P-type portion 84 which, as noted above, is in the range of from $1 \times 10^{16}$ to $5 \times 10^{18}$.

Similarly, the second shield base region 30 is separated into corresponding portions 86 and 88, the portion 86 being doped to a higher concentration than the region 88.

The purpose of the FIG. 2 structure is two-fold. First, for reasons explained in detail in the above-referenced EP 83 103 196.8 the possibility of turn-on of the parasitic SCRs is substantially reduced because voltage drop along the lateral dimension of the shield base regions 28 and 30 is reduced.

Second, in the bidirectional structure of the present invention, whichever of the highly-doped portions 82 and 86 is connected to a positively-biased main terminal serves as an efficient hole injector during conduction. At the same time, the lower doping concentration of whichever of the portions 84 and 88 is connected to the negatively-biased main terminal facilitates the formation of the inversion regions comprising the conduction channels 36 and 38 under influence of the gate voltage.

Considering, for purposes of example, the situation where electrode $MT_1$ is biased positively with respect to electrode $MT_2$, holes are efficiently injected from the highly-doped portions 82 into the active base region 26, where they recombine with electrons from the second terminal region 42 conducted through the induced channel 38.

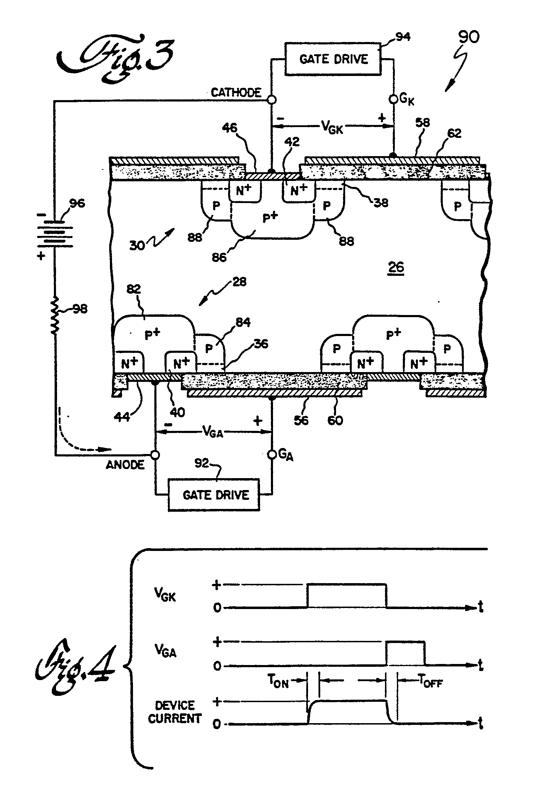

Another aspect of the invention is the concept and method of actively anode-shorted operation of an IGR. For purposes of example, this method is described below with reference to FIGS. 3 and 4 employing the alternative device structure depicted in FIG. 2, although it will be appreciated that the device of FIG. 1 may similarly be operated.

Referring now in detail to FIG. 3, for best understanding of the operational method described, the device terminals have been re-labeled to imply unidirectional operation from a DC source, with the re-labeled device being designated 90. Terminal $MT_1$ of FIG. 2 is labeled as an Anode terminal in FIG. 3 and Terminal $MT_2$ of FIG. 2 is labeled as a Cathode terminal in FIG. 3. The first gate terminal $G_1$ of FIG. 2 is designated an anode gate terminal $G_A$ in FIG. 3, and the second gate terminal $G_2$ of FIG. 2 is designated a cathode gate electrode $G_K$ in FIG. 3.

Connected between the Anode terminal and the anode gate terminal $G_A$ is a source 92 of anode gate drive, the source 92 comprising suitable switching circuitry. Similarly connected between the cathode and the cathode gate $G_K$ terminals is a source 94 of cathode gate drive. An exemplary external circuit comprising a DC power supply or source 96 and a load resistor 98 are connected in series between the device Anode and Cathode terminals. Again, it will be appreciated that, since the device 90 is symmetrical, the connections and terminal designations can all be reversed.

When the anode gate terminal $G_A$ is shorted to the Anode terminal by means of the gate drive circuitry 92, the device 90 blocks reverse current flow because the conduction channel 36 is not induced, and the PN junction between the P conductivity type shield base region 28 (functioning as an anode region) and the N conductivity type active base region 26 is reverse biased.

To condition the device 90 for forward conduction, the circuitry 94 applies positive gate voltage to the cathode gate terminal $G_K$, while the circuitry 94 maintains the anode gate terminal $G_A$ at the same potential as the Anode terminal. In other words, sufficient cathode gate voltage is applied to induce the cathode conduction channel 38, while insufficient gate voltage is applied to the anode gate terminal $G_A$ so that no conduction channel is induced at 36. This allows forward current conduction with good injection efficiency at the anode because the anode is not shorted to the active base region 26. Under these conditions, the PN junction between the P conductivity type region 28 and the N conductivity type active base region 26 is forward biased. Additionally, holes are injected from the $P^+$ portion 86 into the active base region 26 for recombination.

To switch the device to block forward conduction, gate voltage is removed from the cathode gate terminal $G_K$, for example, by shorting the terminal $G_K$ to the cathode through the circuitry 94 and, at the same time, positive bias is applied to the anode gate terminal $G_A$ by the gate drive circuitry 92 to induce the anode inversion channel 36. As a result, the conduction channel or inversion layer 38 in the cathode shield base region 30 no longer exists. At the same time, the inversion channel 36 induced in the anode shield base region 28 creates a shorting path for rapid removal of electrons from the active base region 26 to the device anode terminal 44. The holes in the active base region 26 are removed via the cathode shield base region 30, as is the case in the basic IGR structure summarized hereinabove.

This operation is graphically summarized in FIG. 4, which depicts, on a common time axis representative gate-to-cathode voltage $G_{GK}$ and gate-to-anode $G_{GA}$ waveforms, with the resultant device current. Device turn-on $T_{on}$ and Turn-off $T_{off}$ times are also depicted.

Thus, it will be appreciated that the active anode shorting technique allows fast IGR turn-off, without degrading the reverse blocking capability and anode injection efficiency. Further, the IGR structure is bidirectional in that it is capable of controlling current flow for both applied polarities.

While specific embodiments of the invention have been illustrated and described herein, it is realized that numerous modifications and changes will occur to those skilled in the art. For example, the invention applies to complementary devices, wherein P-type regions are used in place of the N-type regions described herein and vice-versa. It is therefore to be understood that the appended claims are intended to cover all such modifications and changes as fall within the scope of the invention.

**Claims**

1. A bidirectional insulated-gate rectifier comprising:
a body (12) of semiconductor material including an active base region (26) of one conductivity type;
first and second shield base regions (28, 30) of opposite conductivity types formed in said body;
first and second main terminal structures (32, 34) respectively including first and second main terminal electrodes (44, 46); and
first and second gate electrodes (56, 58);
characterized in that
said shield base regions (28, 30) include at least portions doped higher in concentration than said active base region (26),
said first and second main terminal structures (32, 34) are spaced from said active base region (26) to define respective first and second channel portions (36, 38) in said first and second shield base regions (28, 30) extending between each of said respective terminal structures (32, 30) and said active base region (26);
said first and second gate electrodes (56, 58) being respectively disposed over said first and second channel portions (36, 38) and insulatingly spaced therefrom;
said first gate electrode (56) being configured for inducing in said first channel portion (36) when a gate voltage is applied thereto, a first inversion region of the one conductivity type, conductively coupling the first main terminal structure (32) and the active base region;
said second gate electrode (58) being configured for inducing in said second channel portion (38) when a gate voltage is applied thereto, a second inversion region of the one conductivity type, conductively coupling the second main terminal structure (34) and the active base region;
said active base region (26), said shield base regions (28, 30) and said terminal structures (32, 34) provide for conduction in a first direction between said first and second main terminal electrodes (44, 46) through said first channel portion (36) when said first inversion region exists, and ceases to support conduction in the one direction when said first inversion region no longer exists; and
said active base region (26), said shield base regions (28, 30) and said terminal structures (32, 34) provide for conduction in a second direction between said second and said first main terminal electrodes (46, 44) through said second channel portion (38) when said second inversion region exists, and ceases to support conduction in the second direction when said second inversion region no longer exists.

2. A bidirectional insulated-gate rectifier in accordance with claim 1, wherein said main terminal structures (32, 34) respectively further include first and second main terminal regions (40, 42) of the one conductivity type formed in said body (12) respectively within said shield base regions (28, 30), and wherein said main terminal electrodes (44, 46) respectively contact said main terminal regions (40, 42).

3. A bidirectional insulated-gate rectifier in accordance with claim 2, wherein said main terminal electrodes (44, 46) respectively additionally contact said shield base regions (28, 30) to provide shorts between each of said main terminal regions (40, 42) and the respective shield base region (28, 30).

4. A bidirectional insulated-gate rectifier in accordance with claim 2, wherein:
said active base region (26) is of N conductivity type;

said shield base regions (28, 30) are of P conductivity type;

said main terminal regions (40, 42) are of N conductivity type; and

said gate electrodes (56, 58) are configured for inducing inversion channel regions of N conductivity type when biased positively with respect to the corresponding main terminal region (40, 42).

5. A bidirectional insulated-gate rectifier in accordance with claim 1, wherein said shield base regions (28, 30) each include two portions (82, 84 or 86, 88), one of the portions being doped higher in concentration than the other, and said gate electrodes (56, 58) being respectively configured for inducing the inversion channel regions in said other portions.

6. A bidirectional insulated-gate rectifier comprising:

a body (12) of semiconductor material including an active base region (26) of one conductivity type;

first and second shield base regions (28, 30) of opposite conductivity type formed in said body;

first and second main terminal region (40, 42) respectively including first and second main terminal electrodes (44, 46); and

first and second gate electrodes (56, 58);

characterized in that

said first and second shield base regions (28, 30) are island-like opposed shield base regions formed in said body on opposite sides of said body within said active base region, and said shield base regions include at least portions doped higher in concentration than said active base region (26);

said first and second main terminal regions (40, 42) are island-like and spaced from said active base region (26) to define respective channel portions (36, 38) in said first and second shield base regions (28, 30) extending between each of said respective main terminal regions (32, 34) and said active base region (26);

said first and second main terminal electrodes (44, 46) respectively contacting said main terminal regions (40, 42) and the respective shield base regions (28, 30);

said first and second gate electrodes (56, 58) being respectively disposed over said first and second channel portions (36, 38) and insulatingly spaced therefrom;

said first gate electrode (56) being configured for inducing in said first channel portion (36) when a gate voltage is applied thereto, a first inversion region of the one conductivity type, conductively coupling the first main terminal structure (32) and the active base region;

said second gate electrode (58) being configured for inducing in said second channel portion (38) when a gate voltage is applied thereto, a second inversion region of the one conductivity type, conductively coupling the second main terminal structure (20) and the active base region;

said active base region (26), said shield base regions (28, 30) and said terminal structures (32, 20) provide for conduction in a first direction between the first and second main terminal electrodes (32, 20) through said first channel portion (36) when said first inversion region exists, and ceases to support conduction in the one direction when said first inversion region no longer exists; and

said active base region (26), said shield base regions (28, 30) and said terminal structures (32, 20) provide for conduction in a second direction between said second and said first main terminal electrodes (46, 44) through said second channel portion when said second inversion region exists, and ceases to support conduction in the second direction when said second inversion region no longer exists.

7. A bidirectional insulated-gate rectifier in accordance with claim 6 wherein:

said active base region (26) is of N conductivity type;

said shield base regions (28, 30) are of P conductivity type;

said main terminal regions (40, 42) are of N conductivity type; and

said gate electrodes (56, 58) are configured for inducing inversion channel regions of N conductivity type when biased positively with respect to the corresponding main terminal region (40, 42).

8. A bidirectional insulated-gate rectifier in accordance with claim 6, wherein said shield base regions (28, 30) each include two portions (82, 84 or 86, 88), one of the portions being doped higher in concentration than the other, and said gate electrodes (56, 58) being respectively configured for inducing the inversion channel regions in said other portions.

9. A method for operating a semiconductor device including: a body of semiconductor material having an active base region of one conductivity type; anode and cathode shield base regions each of the opposite conductivity type formed in the body; device anode and cathode terminal regions both of the one conductivity type spaced from the active base region to define respective channel portions in said anode and cathode shield base regions extending between each of the respective terminal regions and the active base region; anode and cathode terminal electrodes respectively contacting the anode and cathode terminal regions and also respectively contacting the anode shield base and cathode shield base regions; and anode and cathode gate electrodes respectively disposed over the channel portions and insulatingly spaced therefrom, the gate electrodes being configured for respectively inducing in the channel portions, when gate voltage is applied thereto, respective inversion channel regions of the one conductivity type conductively coupling the respective main terminal region and the active base regions; said method comprising;

applying appropriate voltages to conditioning the device to support forward conduction by applying gate voltage to the cathode-side gate electrode for inducing an inversion channel in the cathode shield base region conductively coupling the cathode terminal region and the active base region, while applying insufficient gate voltage to the anode insulated gate electrode such that no inversion channel is induced in the anode shield base region between the anode terminal region and the active base region; and

subsequently applying appropriate voltages to the device to block forward conduction by removing the gate voltage from the cathode-side gate electrode such that the inversion channel conductively coupling the cathode terminal region and the active base region no longer exists, while applying gate voltage to the anode-side gate electrode for inducing an inversion channel conductively coupling the anode terminal region and the active base region.

**Patentansprüche**

1. Bidirektionaler Oberflächen-Gleichrichter enthaltend:

einen Körper (12) aus Halbleitermaterial mit einem aktiven Basisbereich (26) des einen Leitfähigkeitstyps,

erste und zweite Schutzbasisbereiche (28, 30) des entgegengesetzten Leitfähigkeitstyps in dem Körper,

erste und zweite Hauptanschlußstrukturen (32, 34), die auf entsprechende Weise erste und zweite Hauptanschlußelektroden (44, 46) aufweisen, und

erste und zweite Gateelektroden (56, 58),

dadurch gekennzeichnet, daß

die Schutzbasisbereiche (28, 30) wenigstens Abschnitte aufweisen, die in der Konzentration höher dotiert sind als der aktive Basisbereich (26),

die ersten und zweiten Hauptanschlußstrukturen (32, 34) im Abstand von dem aktiven Basisbereich (26) angeordnet sind, um entsprechende erste und zweite Kanalabschnitte (36, 38) in den ersten und zweiten Schutzbasisbereichen (28, 30) zu bilden, die sich zwischen jeder der entsprechenden Anschlußstrukturen (32, 30) und dem aktiven Basisbereich (26) erstrecken,

die ersten und zweiten Gateelektroden (56, 58) auf entsprechende Weise über den ersten und zweiten Kanalabschnitten (36, 38) angeordnet und isolierend im Abstand davon angeordnet sind,

die erste Gateelektrode (56) so konfiguriert ist, daß, wenn eine Gatespannung daran angelegt ist, in dem ersten Kanalabschnitt (36) ein erster Inversionsbereich des einen Leitfähigkeitstyps induziert wird, der die erste Hauptanschlußstruktur (32) und den aktiven Basisbereich leitend verbindet,

die zweite Gateelektrode (58) so konfiguriert ist, daß, wenn eine Gatespannung daran angelegt ist, in dem zweiten Kanalabschnitt (38) ein zweiter Inversionsbereich des einen Leitfähigkeitstyps induziert wird, der die zweite Hauptanschlußstruktur (34) und den aktiven Basisbereich leitend verbindet,

der aktive Basisbereich (26), die Schutzbasisbereiche (28, 30) und die Anschlußstrukturen (32, 34) für eine Leitung in einer ersten Richtung zwischen den ersten und zweiten Hauptanschlußelektroden (44, 46) durch den ersten Kanalabschnitt (36) sorgen, wenn der erste Inversionsbereich existiert, und die Leitung in der einen Richtung nicht mehr unterstützen, wenn der erste Inversionsbereich nicht länger existiert, und

der aktive Basisbereich (26), die Schutzbasisbereiche (28, 30) und die Anschlußstrukturen (32, 34) für eine Leitung in einer zweiten Richtung zwischen den zweiten und ersten Hauptanschlußelektroden (46, 44) durch den zweiten Kanalabschnitt (38) sorgen, wenn der zweite Inversionsbereich existiert, und die Leitung in der zweiten Richtung nicht mehr unterstützen, wenn der zweite Inversionsbereich nicht länger existiert.

2. Bidirektionaler Oberflächen-Gleichrichter nach Anspruch 1, wobei die Hauptanschlußstrukturen (32, 34) weiterhin erste und zweite Hauptanschlußbereiche (40, 42) des einen Leitfähigkeitstyps aufweisen, die auf entsprechende Weise in dem Körper (12) innerhalb der Schutzbasisbereiche (28, 30) ausgebildet sind, und wobei die Hauptanschlußelektroden (44, 46) auf entsprechende Weise mit den Hauptanschlußbereichen (40, 42) in Kontakt sind.

3. Bidirektionaler Oberflächen-Gleichrichter nach Anspruch 2, wobei die Hauptanschlußelektroden (44, 46) auf entsprechende Weise zusätzlich mit den Schutzbasisbereichen (28, 30) in Kontakt sind, um Kurzschlüsse zwischen jedem der Hauptanschlußbereiche (40, 42) und dem entsprechenden Schutzbasisbereich (28, 30) zu bilden.

4. Bidirektionaler Oberflächen-Gleichrichter nach Anspruch 2, wobei:

der aktive Basisbereich (26) N-Leitfähigkeit hat,

die Schutsbasisbereiche (28, 30) P-Leitfähigkeit haben,

die Hauptanschlußbereiche (40, 42) N-Leitfähigkeit haben und

die Gateelektroden (56, 58) konfiguriert sind zum Induzieren von Inversionskanalabschnitten mit N-Leitfähigkeit, wenn sie in bezug auf den entsprechenden Hauptanschlußbereich (40, 42) positiv vorgespannt sind.

5. Bidirektionaler Oberflächen-Gleichrichter nach Anspruch 1, wobei die Schutzbasisbereiche (28, 30) jeweils zwei Abschnitte (82, 84 oder 86, 88) aufweisen, wobei der eine der Abschnitte mit einer höheren Konzentration dotiert ist als der andere, und die Gateelektroden (56, 58) auf entsprechende Weise konfiguriert sind zum Induzieren der Inversionskanalbereiche in den anderen Abschnitten.

6. Bidirektionaler Oberflächen-Gleichrichter enthaltend:

einen Körper (12) aus Halbleitermaterial mit einem aktiven Basisbereich (26) des einen Leitfähigkeitstyps,

erste und zweite Schutzbasisbereiche (28, 30) des entgegengesetzten Leitfähigkeitstyps in dem Körper,

erste und zweite Hauptanschlußstrukturen (32, 34), die auf entsprechende Weise erste und zweite Hauptanschlußelektroden (44, 46) aufweisen, und

— erste und zweite Gateelektroden (56, 58),
dadurch gekennzeichnet, daß

die ersten und zweiten Schutzbasisbereiche (28, 30) inselähnliche, gegenüberliegende Schutzbasisbereiche sind, die in dem Körper auf gegenüberliegenden Seiten des Körpers innerhalb des aktiven Basisbereiches ausgebildet sind, und die Schutzbasisbereiche wenigstens Abschnitte aufweisen, die in der Konzentration höher dotiert sind als der aktive Basisbereich (26), die ersten und zweiten Hauptanschlußbereiche (40, 42) inselähnlich und im Abstand von dem aktiven Basisbereich (26) angeordnet sind, um entsprechende Kanalabschnitte (36, 38) in den ersten und zweiten Schutzbasisbereichen (28, 30) zu bilden, die sich zwischen jedem der entsprechenden Hauptanschlußbereiche (32, 34) und dem aktiven Bereich (26) erstrecken,

die ersten und zweiten Hauptanschlußelektroden (44, 46) auf entsprechende Weise mit den Hauptanschlußbereichen (40, 42) und den entsprechenden Schutzbasisbereichen (28, 30) in Kontakt sind,

die ersten und zweiten Gateelektroden (56, 58) auf entsprechende Weise über den ersten und zweiten Kanalabschnitten (36, 38) und isolierend im Abstand davon angeordnet sind,

die erste Gateelektrode (56) so konfiguriert ist, daß, wenn eine Gatespannung daran angelegt ist, in dem ersten Kanalabschnitt (36) ein erster Inversionsbereich des einen Leitfähigkeitstyps induziert wird, der die erste Hauptanschlußstruktur (32) und den aktiven Basisbereich leitend verbindet,

die zweite Gateelektrode (58) so konfiguriert ist, daß, wenn eine Gatespannung daran angelegt ist, in dem zweiten Kanalabschnitt (38) ein zweiter Inversionsbereich des einen Leitfähigkeitstyps induziert wird, der die zweite Hauptanschlußstruktur (34) und den aktiven Basisbereich leitend verbindet,

der aktive Basisbereich (26), die Schutzbasisbereiche (28, 30) und die Anschlußstrukturen (32, 34) für eine Leitung in einer ersten Richtung zwischen den ersten und zweiten Hauptanschlußelektroden (44, 46) durch den ersten Kanalabschnitt (36) sorgen, wenn der erste Inversionsbereich existiert, und die Leitung in der einen Richtung nicht mehr unterstützen, wenn der erste Inversionsbereich nicht länger existiert, und

der aktive Basisbereich (26), die Schutzbasisbereiche (28, 30) und die Anschlußstrukturen (32, 34) für eine Leitung in einer zweiten Richtung zwischen den zweiten und ersten Hauptanschlußelektroden (46, 44) durch den zweiten Kanalabschnitt (38) sorgen, wenn der zweite Inversionsbereich existiert, und die Leitung in der zweiten Richtung nicht mehr unterstützen, wenn der zweite Inversionsbereich nicht länger existiert.

7. Bidirektionaler Oberflächen-Gleichrichter nach Anspruch 6, wobei:

der aktive Basisbereich (26) N-Leitfähigkeit hat,
die Schutzbasisbereiche (28, 30) P-Leitfähigkeit haben,

die Hauptanschlußbereiche (40, 42) N-Leitfähigkeit haben und

die Gateelektroden (56, 58) konfiguriert sind zum Induzieren von Inversionskanalabschnitten mit N-Leitfähigkeit, wenn sie in bezug auf den entsprechenden Hauptanschlußbereich (40, 42) positiv vorgespannt sind.

8. Bidirektionaler Oberflächen-Gleichrichter nach Anspruch 6, wobei die Schutzbasisbereiche (28, 30) jeweils zwei Abschnitte (82, 84 oder 86, 88) aufweisen, wobei der eine der Abschnitte mit einer höheren Konzentration dotiert ist als der andere, und die Gateelektroden (56, 58) auf entsprechende Weise konfiguriert sind zum Induzieren der Inversionskanalbereiche in den anderen Abschnitten.

9. Verfahren zum Betreiben einer Halbleitervorrichtung enthaltend: einen Körper aus Halbleitermaterial mit einem aktiven Basisbereich des einen Leitfähigkeitstyps, Anoden- und Katodenschutzbasisbereiche, die jeweils mit dem entgegengesetzten Leitfähigkeitstyp in dem Körper ausgebildet sind, Anoden- und Katoden-Anschlußbereiche der Vorrichtung, die beide den einen Leitfähigkeitstyp aufweisen und im Abstand von dem aktiven Basisbereich angeordnet sind, um entsprechende Kanalabschnitte in den Anoden- und Katoden-Schutzbasisbereichen zu bilden, die sich zwischen jedem der entsprechenden Anschlußbereiche und dem aktiven Basisbereich erstrecken, Anoden- und Katoden-Anschlußelektroden, die auf entsprechende Weise mit den Anoden- und Katoden-Anschlußbereichen in Kontakt sind und auch auf entsprechende Weise mit den Anoden-Schutzbasis- und Katoden-Schutzbasisbereichen in Kontakt sind, und Anoden- und Katoden-Gateelektroden, die auf entsprechende Weise über den Kanalabschnitten angeordnet und isolierend im Abstand davon angeordnet sind, wobei die Gateelektroden so konfiguriert sind, daß sie auf entsprechende Weise in den Kanalabschnitten, wenn eine Gatespannung daran angelegt ist, entsprechende Inversionskanalbereiche des einen Leitfähigkeitstyps induzieren, die den entsprechenden Hauptanschlußbereich und die aktiven Basisbereiche leitend verbinden, wobei das Verfahren aufweist:

Anlegen geeigneter Spannungen zum Konditionieren der Vorrichtung, um eine Vorwärtsleitfähigkeit zu unterstützen durch Anlegen einer Gatespannung an die katodenseitige Gateelektrode zum Induzieren eines Inversionskanals in dem Katoden-Schutzbasisbereich, der den Katodenanschlußbereich und den aktiven Basisbereich leitend verbindet, während eine unzureichende Gatespannung an die anodenseitige Gateelektrode angelegt wird, so daß kein Inversionskanal in dem Anoden-Schutzbasisbereich zwischen dem Anoden-Anschlußbereich und dem aktiven Basisbereich induziert wird, und

anschließendes Anlegen geeigneter Spannungen an die Vorrichtung, um eine Vorwärtsleitung zu sperren durch Beseitigen der Gatespannung von der katodenseitigen Gateelektrode, so daß der Inversionskanal, der den Katoden-Anschlußbereich und den aktiven Basisbereich leitend verbindet, nicht länger existiert, während eine Gatespannung an die anodenseitige Gateelektrode angelegt wird zum Induzieren eines Inversionskanals, der den Anoden-Anschlußbereich und den aktiven Basisbereich leitend verbindet.

## Revendications

1. Un redresseur à porte isolée bidirectionnel comprenant:

un bloc (12) de matière semiconductrice comprenant une région de base active (26) d'un premier type de conductivité;

des première et seconde régions de base écran (28, 30) ayant des types de conductivité opposés et formées dans le bloc précité;

des première et seconde structures de borne principale (32, 34) comprenant respectivement des première et seconde électrodes de borne principale (44, 46); et

des première et seconde électrodes de porte (56, 58);

caractérisé en ce que

les régions de base écran (28, 30) comprennent au moins des parties dopées avec une concentration plus élevée que celle de la région de base active (26),

les première et seconde structures de borne principale (32, 34) sont espacées de la région de base active (26) pour définir respectivement des première et seconde parties de canal (36, 38) dans les première et seconde régions de base écran (28, 30), ces parties de canal s'étendant entre chacune des structures de borne respectives (32, 30) et la région de base active (26);

les première et seconde électrodes de porte sont respectivement disposées sur les première et seconde parties de canal (36, 38) et sont espacées de ces dernières, avec isolation;

la première électrode de porte (56) a une configuration prévue de façon à induire dans la première partie de canal (36), lorsqu'une tension de porte lui est appliquée, une première région d'inversion du premier type de conductivité, qui relie de façon conductrice la première structure de borne principale (32) et la région de base active;

la seconde électrode de porte (58) a une configuration prévue pour induire dans la seconde partie de canal (38) lorsqu'une tension de porte lui est appliquée, une seconde région d'inversion du premier type de conductivité, qui relie de façon conductrice la seconde structure de borne principale (34) et la région de base active;

la région de base active (26), les régions de base écran (28, 30) et les structures de borne (32, 34) assurent la conduction dans une première direction entre les première et seconde électrodes de borne principale (44, 46), par l'intermédiaire de la première partie de canal (36), lorsque la première région d'inversion existe, et elles cessent de permettre la conduction dans la première direction lorsque la première région d'inversion n'existe plus; et

la région de base active (26), les régions de base écran (28, 30) et la structure de borne (32, 34) assurent la conduction dans une seconde direction entre les seconde et première électrodes de borne principale (46, 44), par la seconde partie de canal (38), lorsque la seconde région d'inversion existe, et elles cessent de permettre la conduction dans la seconde direction lorsque la seconde région d'inversion n'existe plus.

2. Un redresseur à porte isolée bidirectionnel conforme à la revendication 1, dans lequel les structures de borne principale (32, 34) comprennent respectivement en outre des première et seconde régions de borne principale (40, 42) du premier type de conductivité, formées dans le bloc (12), respectivement à l'intérieur des régions de base écran (28, 30), et dans lequel les électrodes de borne principale (44, 46) viennent respectivement en contact avec les régions de borne principale (40, 42).

3. Un redresseur à porte isolée bidirectionnel selon la revendication 2, dans lequel les électrodes de borne principale (44, 46) viennent en outre respectivement en contact avec les régions de base écran (28, 30) pour établir des courts-circuits entre chacune des régions de borne principale (40, 42) et la région de base écran respective (28, 30).

4. Un redresseur à porte isolée bidirectionnel selon la revendication 2, dans lequel:

la région de base active (26) est du type de conductivité N;

les régions de base écran (28, 30) sont du type de conductivité P;

les régions de borne principale (40, 42) sont du type de conductivité N; et

les électrodes de porte (56, 58) ont une configuration prévue pour induire des régions de canal d'inversion de type de conductivité N lorsqu'elles sont polarisées positivement par rapport à la région de borne principale correspondante (40, 42).

5. Un redresseur à porte isolée bidirectionnel selon la revendication 1, dans lequel chacune des régions de base écran (28, 30) comprend deux parties (82, 84 ou 86, 88), l'une de ces parties étant dopée avec une concentration supérieure à celle de l'autre, et les électrodes de porte (56, 58) ont des configurations respectivement prévues de façon à induire les régions de canal d'inversion dans ces autres parties.

6. Un redresseur à porte isolée bidirectionnel comprenant:

un bloc (12) de matière semiconductrice comprenant une région de base active (26) d'un premier type de conductivité;

des première et seconde régions de base écran (28, 30) du type de conductivité opposé, formées dans ce bloc;

des première et seconde régions de borne principale (40, 42) qui comprennent respectivement des première et seconde électrodes de borne principale (44, 46); et

des première et seconde électrodes de porte (56, 58);

caractérisé en ce que

les première et seconde régions de base écran (28, 30) sont des régions de base écran opposées, en forme d'îlots, formées dans le bloc sur des côtés opposés de ce dernier, dans la région de base active, et ces régions de base écran comprennent au moins des parties dopées avec une concentration supérieure à celle de la région de base active (26);

les première et seconde régions de borne principale (40, 42) ont la forme d'îlots et elles sont espacées par raport à la région de base active (26), pour définir dans les première et seconde régions de base écran (28, 30) des parties de canal respectives (36, 38) qui s'étendent entre chacune des régions de borne principale respective (32, 34) et la région de base active (26);

les première et seconde bornes d'électrode principale (44, 46) viennent respectivement en contact avec les régions de borne principale (40, 42) et avec les régions de base écran respectives (28, 30);

les première et seconde électrode de porte (56, 58) sont respectivement disposées au-dessus des première et seconde parties de canal (36, 38) et sont espacées par rapport à des dernières, avec isolation;

la première électrode de porte (56) a une configuration prévue pour induire dans la première partie de canal (36), lorsqu'une tension de porte lui est appliquée, une première région d'inversion du premier type de conductivité, qui relie de façon conductrice la première structure de borne principale (32) et la région de base active;

la seconde électrode de porte (58) a une configuration prévue pour induire dans la seconde partie de canal (38), lorsqu'une tension de porte lui est appliquée, une seconde région d'inversion du premier type de conductivité, qui relie de façon conductrice la seconde structure de borne principale (20) at la région de base active;

la région de base active (26), les régions de base écran (28, 30) et les structures de borne (32, 20) assurent la conduction dans une première direction entre les première et seconde électrodes de borne principale (32, 20), par la première partie de canal (36), lorsque la première région d'inversion existe, et elles cessent de permettre la conduction dans la première direction lorsque la première région d'inversion n'existe plus; et

la région de base active (26), les régions de base écran (28, 30) et la structure de borne (32, 20) assurent la conduction dans une seconde direction entre les seconde et première électrodes de borne principale (46, 44), par la seconde partie de canal, lorsque la seconde région d'inversion existe, et elles cessent de permettre la conduction dans la seconde direction lorsque la seconde région d'inversion n'existe plus.

7. Un redresseur à porte isolée bidirectionnel selon la revendication 6, dans lequel:

la région de base active (26) est du type de conductivité N;

les régions de base écran (28, 30) sont du type de conductivité P;

les régions de borne principale (40, 42) sont du type de conductivité N; et

les électrodes de porte (56, 58) ont une configuration prévue pour induire des régions de canal d'inversion du type de conductivité N, lorsqu'elles sont polarisées positivement par rapport à la région de borne principale correspondante (40, 42).

8. Un redresseur à porte isolée bidirectionnel selon la revendication 6, dans lequel chacune des régions de base (28, 30) comprend deux parties (82, 84 ou 86, 88), l'une de ces parties est dopée avec une concentration plus élevée que l'autre, et les électrodes de porte (56, 58) ont des configurations respectives prévues pour induire les régions de canal d'inversion dans ces autres parties.

9. Un procédé pour faire fonctionner un dispositif à semiconducteurs comprenant: un bloc de matière semiconductrice ayant une région de base active d'un premier type de conductivité; des régions de base écran d'anode et de cathode qui sont formées dans le bloc et sont toutes deux du type de conductivité opposé; des régions de borne d'anode et de cathode du dispositif, toutes deux du premier type de conductivité, espacées par rapport à la région de base active pour définir dans les régions de base active d'anode et de cathode, des parties de canal respectives qui s'étendent entre chacune des régions de borne respectives et la région de base active; des électrodes de borne d'anode et de cathode qui viennent respectivement en contact avec les régions de borne d'anode et de cathode, et qui viennent également respectivement en contact avec les régions de base écran d'anode et de base écran de cathode; et des électrodes de porte d'anode et de cathode qui sont respectivement disposées sur les parties de canal et espacées par rapport à ces dernières, avec isolation, les électrodes de porte ayant une configuration prévue pour induire respectivement dans les parties de canal, lorsqu'une tension de porte leur est appliquée, des régions de canal d'inversion respectives du premier type de conductivité, qui relient de façon conductrice la région de borne principale respective et les régions de base active; ce procédé comprenant les opérations suivantes:

on applique des tensions appropriées pour placer le dispositif dans des conditions dans lesquelles il permet une conduction en sens direct, par l'application d'une tension de porte à l'électrode de porte du côté cathode, pour induire dans la région de base écran de cathode un canal d'inversion qui connecte de façon conductrice la région de borne de cathode et la région de base active, tout en appliquant une tension de porte insuffisante à l'électrode de porte isolée d'anode, de façon qu'aucun canal d'inversion ne soit induit dans la région de base écran d'anode, entre la région de borne d'anode et la région de base active; et

on applique ensuite des tensions appropriées au dispositif pour bloquer la conduction en sens direct, en supprimant la tension de porte appliquée à l'électrode de porte du côté cathode, afin que le canal d'inversion qui connecte de façon conductrice la région de borne de cathode et la région de base active n'existe plus, tout en appliquant une tension de porte à l'électrode de porte du côté anode, pour induire un canal d'inversion qui connecte de façon conductrice la région de borne d'anode et la région de base active.

*Fig. 1*

Fig. 2

*Fig.3*

GATE DRIVE

94

90

CATHODE

$V_{GK}$

GATE DRIVE

92

ANODE

$V_{GA}$

26

30

28

*Fig.4*

$V_{GK}$

$V_{GA}$

$T_{ON}$

$T_{OFF}$

DEVICE CURRENT

3